Europäisches Patentamt

European Patent Office

Office européen des brevets

(19)

(11) Numéro de publication: **0 202 155**
**B1**

(12) **FASCICULE DE BREVET EUROPEEN**

(45) Date de publication du fascicule du brevet: **16.08.90**

(51) Int. Cl.⁵: **H 03 M 11/00, H 03 K 17/96**

(21) Numéro de dépôt: **86400951.9**

(22) Date de dépôt: **30.04.86**

(54) **Dispositif d'identification pour clavier capacitif.**

(30) Priorité: **02.05.85 FR 8506666**

(43) Date de publication de la demande:
**20.11.86 Bulletin 86/47**

(45) Mention de la délivrance du brevet:
**16.08.90 Bulletin 90/33**

(84) Etats contractants désignés:
**DE FR GB IT NL**

(56) Documents cités:
**EP-A-0 062 572**
**WO-A-85/04994**
**US-A-4 145 748**

(73) Titulaire: **Lewiner, Jacques**
**5, rue Bory d'Arnex**
**F-92210 Saint-Cloud (FR)**

(73) Titulaire: **Hennion, Claude**
**14, rue de la Glacière**
**F-75013 Paris (FR)**

(72) Inventeur: **Lewiner, Jacques**
**5, rue Bory d'Arnex**
**F-92210 Saint-Cloud (FR)**
Inventeur: **Hennion, Claude**
**14, rue de la Glacière**
**F-75013 Paris (FR)**

(74) Mandataire: **Behaghel, Pierre et al**
**CABINET PLASSERAUD 84 rue d'Amsterdam**
**F-75009 Paris (FR)**

Courier Press, Leamington Spa, England.

**Description**

L'invention concerne les ensembles électroniques associés aux claviers capacitifs en vue d'identifier les touches enfoncées de ces claviers.

Plus précisément elle concerne les ensembles du genre indiqué destinés à lire, en vue de leur exploitation ultérieure les informations élaborées à l'aide des claviers comportant une pluralité de touches de type capacitif réparties selon un arrangement matriciel, c'est-à-dire disposées aux points de croisement d'un quadrillage composé de m lignes et n colonnes, m et n étant des entiers généralement compris entre 8 et 16.

Dans les claviers en question chaque touche est associée à un condensateur et son enfoncement se traduit par une forte variation de la capacité de ce condensateur.

Les deux électrodes de chaque condensateur correspondant à la ligne i et à la colonne j (i étant un entier compris entre l et m et j étant un entier compris entre l et n) sont connectées respectivement la première aux premières électrodes des autres condensateurs de la ligne i et la seconde, aux secondes électrodes des autres condensateurs de la colonne j.

L'enfoncement de la touche associée à un tel condensateur a alors pour effet de "coupler capacitivement" la ligne i et la colonne j.

Pour identifier chaque touche enfoncée dans un tel clavier, il est prévu des moyens pour appliquer successivement, sur les entrées des m lignes, des trains de n impulsions identiques successives espacées mutuellement dans le temps de durées t identiques, des moyens pour collecter successivement sur les sorties des n colonnes les signaux créés par les impulsions ci-dessus, les n sorties étant à cet effet balayées successivement au rythme t et ce balayage étant renouvelé m fois de suite, et des moyens pour détecter et identifier, parmi les signaux collectés, les échos qui franchissent un seuil prédéterminé et qui correspondent à des touches enfoncées.

Si seule la touche correspondant à la ligne i et à la colonne j du clavier est enfoncée à un instant donné, le seul écho détecté et identifié par l'exploration ci-dessus décrite correspond à l'impulsion de rang j du train de rang i.

Les ensembles d'identification du genre indiqué donnent satisfaction lorsque les variations de capacité des condensateurs associés aux touches, sont suffisamment importantes par rapport aux capacités de couplage parasites existant entre les lignes et les colonnes.

Mais ce n'est plus le cas lorsque ces capacités parasites sont relativement importantes au point d'être du même ordre de grandeur que les variations considérées, lesdites capacités et variations étant par exemple toutes les deux de l'ordre de 10 pF.

Dans un tel cas en effet, les échos d'identification ci-dessus décrits, qui correspondent aux touches véritablement enfoncées du clavier à un instant donné, ne diffèrent pas suffisamment des signaux parasites créés au même instant au niveau de certaines au moins des touches non enfoncées.

Il devient alors hasardeux de confier sans autre précaution aux moyens collecteurs la mission de l'identification des échos.

Ces moyens sont en effet sensibles uniquement aux niveaux logiques hauts ou bas des signaux électriques représentatifs de ces échos et non pas aux amplitudes véritables desdits signaux.

Pour remédier à cet inconvénient, il a déjà été proposé de régler le niveau de détection des signaux en question en comparant chacun d'eux, dans un comparateur approprié, à une tension de référence déterminée en fonction des caractéristiques du clavier, lors de la fabrication de celui-ci: lesdits signaux et ladite référence sont reçues respectivement sur les deux entrées du comparateur et seuls sont retenus les signaux dont l'amplitude dépasse celle de la référence.

Les ensembles ainsi perfectionnés constituent un progrès mais ne donnent pas satisfaction dans tous les cas.

En effet, la valeur de la référence y est déterminée une fois pour toutes et ne demeure pas idéale ni même appropriée dans toutes les circonstances.

C'est ainsi que certains parasites extérieurs, notamment du type électromagnétique, peuvent affecter simultanément l'état de la totalité des touches du clavier au point de majorer exagérément à un instant donné le signal de sortie recueilli sur la colonne exploitée à cet instant et de faire interpréter ce signal comme correspondant à une touche enfoncée même si aucune des touches de cette colonne n'est alors enfoncée.

Pour écarter cet inconvénient, il a déjà été proposé de régler à chaque instant la référence de compensation en fonction de l'état réel à cet instant des différentes touches composant au moins deux colonnes du clavier et, à cet effet, de donner à ladite référence une amplitude M liée à la moyenne des amplitudes des signaux recueillis audit instant sur ladite colonne, cf. EP-A-62572.

Cette formule constitue un progrès par rapport à la précédente pour le cas où l'on désire protéger le clavier vis-à-vis des parasites relativement intenses et de très courte durée.

Mais elle ne permet pas de compenser certains troubles tels que celui résultant du maintien enfoncé simultané d'une pluralité de touches du clavier disposées sur une même ligne.

En effet, dans un tel cas, la moyenne M d'amplitudes des signaux recueillis sur les différentes colonnes correspondant à ces touches varie elle-même au rythme des impulsions appliquées sur la ligne considérée et il peut arriver qu'un signal utile destiné à identifier l'enfoncement d'une touche d'une autre ligne ne diffère plus lui-même suffisamment de la référence M élaborée au même instant pour être véritablement identifié comme "utile".

L'invention permet de remédier à cet inconvénient et aux autres du même genre.

A cet effet, selon l'invention, les ensembles électroniques d'identification du genre ci-dessus sont essentiellement caractérisés en ce qu'ils comprennent des moyens pour donner à chaque instant à l'amplitude de la référence une valeur T qui est une moyenne dans le temps de la moyenne M d'amplitudes.

Dans un tel cas, dans pratiquement toutes les situations, l'amplitude de chaque signal utile demeure nettement supérieure à celle de la référence T élaborée en même temps que ce signal et est donc correctement identifiée.

La durée D adoptée pour la moyenne dans le temps est de préférence comprise entre 0,2 et 5 B, B étant la durée du balayage des colonnes qui interviennent pour l'élaboration de la moyenne d'amplitudes M.

Dans la pratique cette durée D est comprise entre 5 et 200 ms, et de préférence entre 50 et 150 ms.

Dans des modes de réalisation préférés, on a recours en outre à l'une et/ou à l'autre des dispositions suivantes:

les moyens pour effectuer la moyenne T dans le temps de la moyenne d'amplitudes M comprennent un condensateur d'intégration reliant à la masse la seconde entrée du comparateur,

l'ensemble d'identification comprend d'une part une résistance électrique de rappel associée à la seconde entrée du comparateur et d'autre part une résistance électrique de pondération directement interposée entre cette seconde entrée et chacune des sorties de colonnes exploitées pour l'élaboration de la moyenne d'amplitudes M

dans le cas où les nombres des touches du clavier correspondant aux différentes colonnes sont identiques, les résistances électriques de pondération reliées aux sorties des colonnes extrêmes du clavier diffèrent de celles reliées aux sorties des autres colonnes.

L'invention comprend, mises à part ces dispositions principales, certaines autres dispositions qui s'utilisent de préférence en même temps et dont il sera plus explicitement question ci-après.

La description qui suit en référence au dessin ci-annexé donne un certain nombre de précisions sur ce qui précède à titre illustratif et bien entendu aucunement limitatif.

La figure 1, de ce dessin, est le schéma d'un circuit électronique d'identification connu pour un clavier capacitif.

La figure 2 présente trois courbes explicatives.

La figure 3 est le schéma d'un circuit du genre indiqué ci-dessus tel qu'établi selon l'invention.

Le clavier 1 à exploiter comprend m.n touches 2 réparties selon m lignes et n colonnes.

Chaque touche $2_{ij}$ correspondant à la ligne de rang i et à la colonne de rang j travaille par effet capacitif en ce sens qu'elle est associée à un condensateur $3_{ij}$ dont la capacité est très faible lorsque la touche n'est pas enfoncée et devient relativement élevée lors de l'enfoncement de cette touche ou inversement.

La première électrode de chaque condensateur $3_{ij}$ est reliée aux premières électrodes des condensateurs associés aux touches de la même ligne de rang i par un conducteur $x_i$ et la seconde électrode dudit condensateur $3_{ij}$ est reliée aux secondes électrodes des condensateurs associés à la même colonne de rang j par un conducteur $y_j$.

Pour identifier l'enfoncement de la touche $2_{ij}$, on prévoit un calculateur ou circuit logique évolué 4 agencé de façon:

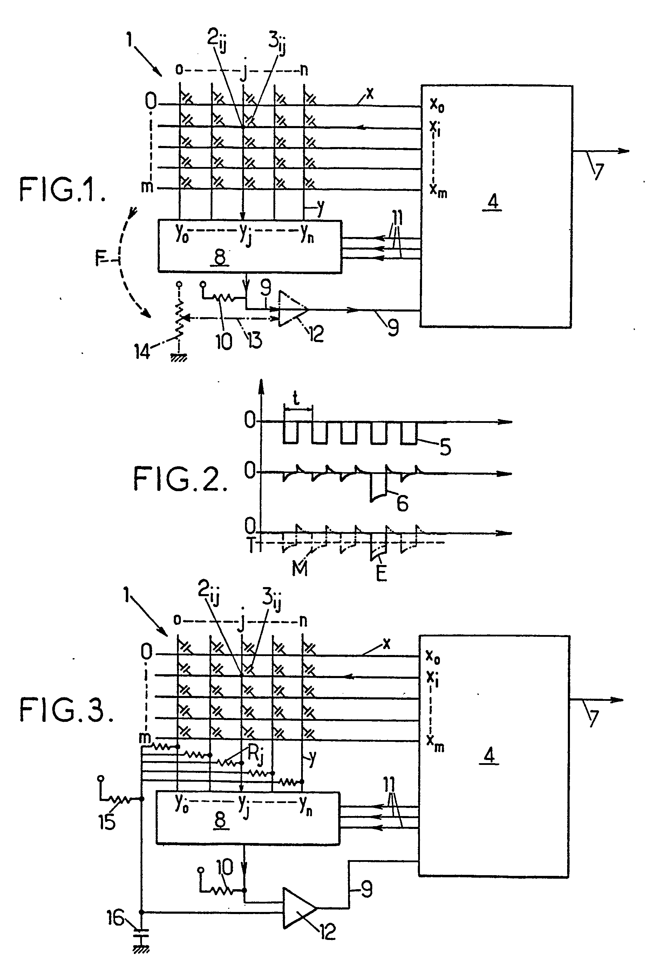

d'une part, à envoyer successivement sur les entrées des m conducteurs x autant de trains de n impulsions 5 (figure 2) décalées régulièrement dans le temps d'intervalles t,

et, d'autre part, à collecter successivement sur les sorties des n conducteurs y les signaux créés sur ces sorties en réponse auxdites impulsions, cette collecte étant effectuée au rythme t et renouvelée m fois.

L'exploration globale du clavier ainsi réalisée est ensuite renouvelée pendant toute la durée de fonctionnement de ce dernier.

Si la touche $2_{ij}$ est enfoncée à un instant donné, le conducteur $x_i$ est couplé capacitivement à la colonne $y_j$ et l'exploration globale considérée se traduit par la création d'un écho 6 sur la sortie de ladite colonne en réponse à l'application, sur l'entrée de la ligne $x_i$, de l'impulsion de rang j du train d'impulsions de rang i; en d'autres termes cet écho correspond à l'impulsion de rang n (i — l) + j de la séquence de trains complète utilisée pour chaque exploration.

L'écho 6 ainsi recueilli et identifié par un codage approprié est envoyé à un dispositif d'exploitation, notamment en vue d'un affichage ou d'une impression de la manière schématisée par la flèche 7.

Sur la figure 1, l'ensemble des sorties des colonnes ont été regroupées dans un multiplexeur 8, ce qui simplifie le retour au calculateur 4, ce retour étant effectué au moyen d'un conducteur unique 9, lui-même relié au potentiel d'alimentation du circuit à travers une résistance 10.

Dans un tel cas, on prévoit une liaison multiple 11 entre le calculateur 4 et le multiplexeur 8 pour commander et synchroniser les lectures successives des sorties des colonnes avec les émissions des impulsions 5.

Le premier perfectionnement connu qui a été signalé ci-dessus et qui fait intervenir une tension de référence fixe a été schématisé en traits mixtes sur la figure 1.

Il met en oeuvre un comparateur 12, constitué de préférence par un amplificateur opérationnel, dont les deux entrées sont connectées respectivement au conducteur 9 ci-dessus et à un conducteur 13 lui-même porté à un potentiel de référence et ce potentiel de référence est réglé une fois pour toutes à l'aide d'un diviseur de tension 14 branché entre le potentiel d'alimentation du circuit et la masse.

Le second perfectionnement connu rappelé ci-dessus revient à appliquer sur la seconde entrée dudit comparateur une tension de référence qui n'est plus réglée une fois pour toutes mais compense automatiquement certains parasites appliqués sur l'ensemble du clavier.

A cet effet la référence en question est établie à partir des signaux recueillis sur les sorties d'au moins deux des colonnes: on donne à l'amplitude de cette référence une valeur M correspondant à la moyenne des amplitudes de ces signaux.

C'est ce qui a été schématisé par la flèche F sur la figure 1.

L'adoption directe de ladite moyenne d'amplitudes M comme référence présente l'inconvénient suivant: cette moyenne peut être elle-même variable au rythme t ci-dessus et donc présenter des amplitudes maximum aux instants de détection des échos ou signaux utiles, ce qui risque dans certains cas de laisser passer de tels échos sans identification, en particulier lorsque ceux-ci sont élaborés avec réduction d'amplitude, par exemple en raison de la présence indésirable de poussières au droit de la touche concernée.

Pour remédier à cet inconvénient, selon l'invention, on adopte comme référence non pas la moyenne d'amplitudes M ci-dessus définie, mais une moyenne T dans le temps de cette moyenne d'amplitudes.

La durée D choisie pour effectuer cette moyenne dans le temps est de préférence comprise entre 0,2 B et 5 B, si B désigne le temps nécessaire au balayage des colonnes intervenant pour l'élaboration de la moyenne M.

Dans la pratique, cette durée D est comprise entre 5 et 200 ms, et de préférence entre 50 et 150 ms.

Sur la portion basse de la figure 2, on a représenté en traits mixtes la moyenne M dans le cas défavorable signalé ci-dessus d'un maintien enfoncé de plusieurs touches d'une même ligne: on voit que l'amplitude de la moyenne T est plus petite que celle des crêtes de cette moyenne M, et risque donc moins d'être confondue avec celle des échos E à détecter que ces crêtes.

Dans le mode de réalisation de l'invention qui a été schématisé sur la figure 3, la seconde entrée de l'amplificateur opérationnel 12 est reliée d'une part au potentiel d'alimentation du circuit par l'intermédiaire d'une résistance de rappel 15 -dont la valeur est choisie de façon à incorporer en permanence à la moyenne T ci-dessus toute composante de tension continue désirable- et d'autre part à chaque sortie de colonne y par l'intermédiaire d'une résistance de pondération R$_j$.

Si les nombres et caractéristiques des différentes touches correspondant aux différentes colonnes sont les mêmes, les résistances de pondération R$_j$ peuvent être toutes identiques entre elles, ou, selon une variante intéressante, elles sont identiques entre elles à l'exception de celles correspondant aux deux colonnes extrêmes du clavier, de façon à tenir compte de la différence d'environnement de ces deux colonnes extrêmes.

Un condensateur d'intégration 16 est prévu entre la seconde entrée de l'amplificateur opérationnel 12 et la masse pour élaborer à chaque instant la moyenne T dans le temps du signal appliqué sur ladite entrée au cours du temps D ci-dessus défini.

Dans ces conditions, la tension de référence T appliquée sur la seconde entrée de l'amplificateur opérationnel 12 est constamment influencée par la totalité des capacités parasites qui se développent réellement au niveau des couplages entre les lignes et colonnes du clavier, quelle que soit l'origine de ces capacités parasites, et en particulier que celles-ci soient dues à des détériorations locales permanentes ou au maintien prolongé de l'enfoncement d'au moins une touche autre que celle à identifier.

En suite de quoi, et quel que soit le mode de réalisation adopté, on dispose finalement de circuits électroniques d'identification de claviers capacitifs dont la constitution, le fonctionnement et les avantages résultent suffisamment de ce qui précède.

Comme il va de soi, et comme il résulte d'ailleurs déjà de ce qui précède, l'invention ne se limite nullement à ceux de ses modes d'application et de réalisation qui ont été plus spécialement envisagés; elle en embrasse, au contraire, toutes les variantes.

**Revendications**

1. Ensemble électronique associé à un clavier capacitif (1) en vue d'identifier les touches (2$_{ij}$) enfoncées de ce clavier, touches qui sont réparties selon un arrangement matriciel, c'est-à-dire disposées aux points de croisement d'un quadrillage composé de m lignes (x$_i$) et n colonnes (y$_j$), comportant des moyens pour appliquer successivement, sur les entrées des m lignes, des trains de n impulsions identiques successives (5) espacées mutuellement dans le temps de durées t identiques, des moyens pour collecter successivement sur les sorties des n colonnes les signaux créés par les impulsions ci-dessus, les n sorties étant à cet effet balayées successivement au rythme t et ce balayage étant renouvelé m fois de suite, des moyens pour détecter et identifier, parmi les signaux collectés, les échos (6) qui dépassent un seuil prédéterminé et qui correspondent à des touches enfoncées, moyens comprenant un comparateur (12) propre à comparer l'amplitude desdits signaux, reçus sur sa première entrée, à celle d'une tension de référence reçue sur sa seconde entrée pour ne retenir que les échos dont l'amplitude (E) dépasse celle de la référence, et des moyens pour donner automatiquement à chaque instant à la référence de comparaison une amplitude liée à la moyenne (M) des amplitudes des signaux élaborés à cet instant sur au moins deux des sorties de colonnes (y$_j$), caractérisé en ce qu'il comporte en outre des moyens pour donner à chaque instant à cette amplitude de la référence une valeur (T) qui est une moyenne dans le temps de ladite moyenne d'amplitudes.

2. Ensemble électronique selon la revendication 1, caractérisé en ce que la période (D) adoptée pour la moyenne dans le temps est comprise entre 5 et 200 ms, de préférence entre 50 et 150 ms.

3. Ensemble électronique selon l'une quelconque des revendications 1 et 2, caractérisé en ce que les moyens pour effectuer la moyenne dans le temps (T) de la moyenne d'amplitudes (M) comprennent un condensateur d'intégration (16) reliant à la masse la seconde entrée du comparateur (12).

4. Ensemble électronique selon l'une quelconque des précédentes revendications, caractérisé en ce qu'il comprend d'une part une résistance électrique de rappel (15) associée à la seconde entrée du comparateur (12) et d'autre part une résistance électrique de pondération $(R_j)$ directement interposée entre cette seconde entrée du comparateur (12) et chacune des sorties de colonne $(y_j)$ exploitées pour l'établissement de la moyenne d'amplitudes (M).

5. Ensemble électronique selon l'une quelconque des précédentes revendications, caractérisé en ce que la moyenne d'amplitudes (M) est établie à partir des amplitudes des signaux élaborés sur la totalité des sorties des colonnes $(y_j)$ du clavier.

6. Ensemble électronique selon la revendication 5, pour lequel les nombres et caractéristiques des touches sont les mêmes pour chaque colonne, caractérisé en ce que les résistances de pondération $(R_j)$ reliées aux sorties des colonnes sont identiques entre elles sauf pour les deux colonnes extrêmes du clavier.

## Patentansprüche

1. Elektronische Einheit, die mit einer kapazitiven Tastatur (1) zum Zweck der Identifizierung der gedrückten Tasten $(2_{ij})$ dieser Tastatur verbunden ist, wobei die Tasten in einer Matrix verteilt sind, d.h. sie liegen auf den Kreuzpunkten eines quadratischen Liniennetzes bestehend aus m Zeilen $(x_i)$ und n Spalten $(y_j)$, wobei die elektronische Einheit eine Einrichtung, um nacheinander an die Eingänge der m Zeilen Reihen von n aufeinanderfolgenden identischen Impulsen (5) in einem zueinander identischen zeitlichen Abstand der Dauer t anzulegen, eine Einrichtung, um an den Ausgängen der n Spalten die durch die oben genannten Impulse erzeugten Signale nacheinander zu erfassen, wobei die n Ausgänge zu diesem Zweck im Rhythmus t nacheinander abgetastet werden und dieses Abtasten m mal in Folge wiederholt wird, eine Einrichtung, um unter den erfaßten Signalen die Echos (6) auszumachen und zu identifizieren, die eine festgelegte Schwelle überschreiten und die mit gedrückten Tasten Übereinstimmen, wobei diese Einrichtung einen Vergleicher (12) umfaßt, der geeignet ist, die Amplitude der besagten Signale, die er an seinem ersten Eingang empfängt, mit der einer Bezugsspannung, die er an seinem zweiten Eingang empfängt, zu vergleichen, um nur diejenigen Echos festzuhalten, deren Amplitude (E) die des Bezugswertes überschreitet, und eine Einrichtung aufweist, um dem Vergleichswert automatisch zu jedem Zeitpunkt eine Amplitude zu geben, die an den Mittelwert (M) der Amplituden der Signale gebunden ist, die in diesem Augenblick an mindestens zwei Ausgängen der Spalten $(y_j)$ erzeugt werden, dadurch gekennzeichnet, daß sie eine weitere Einrichtung aufweist, um dieser Amplitude des Bezugswertes zu jedem Zeitpunkt einen Wert (T) zu geben, der ein zeitlicher Durchschnittswert des genannten Amplituden-Mittelwertes ist.

2. Elektronische Einheit nach Anspruch 1, dadurch gekennzeichnet, daß der für den zeitlichen Durchschnittswert verwendete Zeitabschnitt (D) zwischen 5 und 200 ms, vorzugsweise zwischen 50 und 150 ms, liegt.

3. Elektronische Einheit nach einem der Ansprüche 1 und 2, dadurch gekennzeichnet, daß die Einrichtung, um den zeitlichen Durchschnittswert (T) des Amplituden-Mittelwertes (M) zu erhalten, einen Integrationskondensator (16) umfaßt, der den zweiten Eingang des Vergleichers (12) mit Masse verbindet.

4. Elektronische Einheit nach einem der vorstehenden Ansprüche, dadurch gekennzeichnet, daß sie einerseits einen mit dem zweiten Eingang des Vergleichers (12) verbundenen elektrischen Rückstellwiderstand (15) umfaßt und andererseits einen elektrischen Gleichgewichtswiderstand $(R_j)$, der direkt zwischen diesem zweiten Eingang des Vergleichers (12) und jedem der Spaltenausgänge $(y_j)$ geschaltet ist, die dazu benutzt werden, den Amplituden-Mittelwert (M) zu errechnen.

5. Elektronische Einheit nach einem der vorstehenden Ansprüche, dadurch gekennzeichnet, daß der Amplituden-Mittelwert (M), ausgehend von den Amplituden der Signale, die an der Gesamtheit der Ausgänge der Spalten $(y_j)$ der Tastatur ausgegeben werden, festgelegt wird.

6. Elektronische Einheit nach Anspruch 5, bei der die Anzahl und die Charakteristika der Tasten für jede Spalte gleich sind, dadurch gekennzeichnet, daß die mit den Ausgängen der Spalten verbundenen Gleichgewichtswiderstände $(R_j)$ untereinander identisch sind, bis auf die beiden äußersten Spalten der Tastatur.

## Claims

1. An electronic assembly associated with a capacitive keyboard (1) for identifying the depressed keys $(2_{ij})$ of this keyboard, which keys are distributed in a matrix arrangement, that is to say disposed at the intersection points of a checkerboard pattern formed of m lines $(x_i)$ and n columns $(y_j)$, comprising means for successively applying, to the inputs of the m lines, trains of n successive identical pulses (5) spaced apart mutually in time by identical times t, means for successively collecting from the outputs of the n columns the signals created by the above pulses, the n outputs being for this purpose scanned successively at the timing t and this scanning being renewed m times in succession, means for detecting and identifying, among the collected signals, the echoes (6) which exceed a predetermined threshold and which correspond to depressed keys, means comprising a comparator (12) for comparing the amplitude of said signals, received at its first input, with that of a reference voltage received at its second input for selecting only the echoes whose amplitude (E) exceeds that of the reference, and means for automatically giving at all times to the comparison reference an amplitude related to the mean (M) of the amplitudes of the signals elaborated at that time at at least two of the column (y$_j$) outputs, characterized in that it further comprises means for giving at all times to this amplitude of the reference a value (T) which is an average in time of said amplitudes mean.

2. The electronic assembly as claimed in claim 1, characterized in that the period (D) adopted for the average in time is between 5 and 200ms, preferably between 50 and 150ms.

3. The electronic assembly as claimed in any one of the claims 1 and 2, characterized in that the means for working out the average in time (T) of the amplitudes mean (M) comprises an integration capacitor (16) connecting the second input of the comparator (12) to ground.

4. The electronic assembly as claimed in any one of the preceding claims, characterized in that it comprises, on the one hand, an electric return resistance (15) associated with the second input of the comparator (12) and, on the other hand, an electric weighting resistance (R$_j$) directly interposed between this second input of the comparator (12) and each of the column (y$_j$) outputs used for establishing the amplitudes mean (M).

5. The electronic assembly as claimed in any one of the preceding claims, characterized in that the amplitudes mean (M) is established from the amplitudes of the signals elaborated at the whole of the column (y$_j$) outputs of the keyboard.

6. The electronic assembly as claimed in claim 5, for which the numbers and characteristics of the keys are the same for each column, characterized in that the weighting resistors (R$_j$) connected to the outputs of the columns are identical with each other except for the end two columns of the keyboard.

FIG.1.

FIG.2.

FIG.3.